# EUROPEAN PATENT APPLICATION

(11) **EP 4 836 634 A1**
(43) Date of publication of application: **04.11.2026**
(21) Application number: 25210597.8
(22) Date of filing: 23.10.2025
(51) Int. Cl.: H10D 89/60, H02H 9/04

(54) **CIRCUIT STRUCTURE AND METHOD WITH MULTIPLE DISCHARGE CIRCUITS AND RESISTOR FOR REDUCING DISCHARGED PAD VOLTAGE AT CONTROL NODE FOR DEVICE**

(30) Priority: 28.04.2025 US 202519190906
(71) Applicant: GlobalFoundries U.S. Inc., Malta, NY 12020 (US)
(72) Inventor: Loiseau, Alain F., Malta, 12020 (US); Subramani, Nandha Kumar, Malta, 12020 (US)
(74) Representative: Grünecker Patent- und Rechtsanwälte PartG mbB

(57) **Abstract**

Embodiments of the disclosure provide a circuit structure and method with multiple discharge circuits and a resistor for reducing a discharged pad voltage. A structure of the disclosure includes a first trigger circuit connected between a pad and a ground node. A first discharge circuit is connected between the pad and the ground node, wherein the first discharge circuit is connected to an output node of the first trigger circuit. A second trigger circuit may be connected between the pad and the ground node in parallel with the first trigger circuit. A resistor has a first end connected to the pad and a second end opposite the first end. A second discharge circuit is connected between the second end of the resistor and the ground node. The second discharge circuit is connected to an output node of the first trigger circuit or the second trigger circuit. Related methods are provided.

## Description

### STATEMENT REGARDING FEDERAL RIGHTS

This invention was made with government support under Contract Number HQ0727790700, awarded by the United States Department of Defense. The government has certain rights in the invention.

### TECHNICAL FIELD

Embodiments of the disclosure relate generally to electronic circuits. More specifically, various embodiments of the disclosure provide circuit structures and methods affecting a discharged pad voltage.

### BACKGROUND

Electric circuits, including integrated circuits (ICs), may include discharge elements for protecting the device hardware against events such as electrostatic discharge (ESD) voltages that can cause electrical shorts, dielectric breakdown, and/or other failure modes. In an ideal setting, ESD elements have no effect on the device operation until an ESD event is seen by a pin on an IC where the ESD event turns on the ESD devices and discharges current through the ESD element to power, or ground supply rails. ESD elements may serve no operational purpose until a trigger voltage is applied to the ESD element to activate it.

As device sizes continue to shrink, the operating parameters for discharge elements such as ESD protection circuits have become increasingly sensitive. For example, the discharge elements need to remain in an "off state" for all operations below a predetermined maximum operating voltage. However, the discharge element(s) need to become active above the predetermined maximum operating voltage but below the breakdown voltage level for the device. Conventional configurations for discharge elements have been unable to provide stable maximum operating voltages that are sufficiently below the breakdown voltage, potentially risking negative side effects to certain devices even where the discharge element(s) operate as intended.

### SUMMARY

Aspects of the present disclosure provide a structure including: a first trigger circuit connected between a pad and a ground node; a first discharge circuit connected between the pad and the ground node, wherein the first discharge circuit is connected to an output node of the first trigger circuit; a second trigger circuit connected between the pad and the ground node in parallel with the first trigger circuit; a resistor having a first end connected to the pad and a second end opposite the first end; and a second discharge circuit connected between the second end of the resistor and the ground node, wherein the second discharge circuit is connected to an output node of the second trigger circuit.

Further aspects of the present disclosure provide a structure including: a trigger circuit connected between a pad and a ground node; a first discharge circuit connected between the pad and the ground node, wherein the first discharge circuit is connected to an output node of the trigger circuit; a resistor having a first end connected to the pad and a second end opposite the first end; and a second discharge circuit connected between the second end of the resistor and the ground node, wherein the second discharge circuit is connected to the output node of the trigger circuit.

Additional aspects of the present disclosure provide a method including: providing a structure including: a pad; a first discharge circuit connected between the pad and a ground node; a resistor having a first end connected to the pad and a second end opposite the first end; and a second discharge circuit connected between the second end of the resistor and the ground node; enabling the first discharge circuit when a pad voltage on the pad is above a first predetermined operating voltage; and concurrently enabling the second discharge circuit when the pad voltage on the pad is above a second predetermined operating voltage.

### BRIEF DESCRIPTION OF THE DRAWINGS

These and other features of this disclosure will be more readily understood from the detailed description of the various aspects of the disclosure taken in conjunction with the accompanying drawings that depict various embodiments of the disclosure, in which:
FIG. 1 provides a schematic view of a circuit structure with multiple discharge circuits and a resistor according to embodiments of the disclosure.
FIG. 2 provides an expanded schematic view of a circuit structure and device according to embodiments of the disclosure.
FIG. 3 shows a cross-sectional view of a high electron mobility transistor (HEMT) configured for implementation within a discharge circuit according to embodiments of the disclosure.
FIG. 4 provides a schematic view of a circuit structure with example implementations of trigger circuits and discharge circuits according to embodiments of the disclosure.
FIG. 5 provides a schematic view of a circuit structure with multiple discharge circuits and a resistor according to further embodiments of the disclosure.
FIG. 6 provides a schematic view of a circuit structure with example implementations of a trigger circuit and discharge circuits according to further embodiments of the disclosure.
FIG. 7 shows an illustrative plot of current (I) within a device versus pad voltage (V_{A}) during operation with different resistances according to embodiments of the disclosure.
FIG. 8 provides an illustrative flow diagram of methods for operating a circuit structure with multiple discharge circuits and a resistor according to embodiments of the disclosure.

It is noted that the drawings of the disclosure are not necessarily to scale. The drawings are intended to depict typical aspects of the disclosure, and therefore should not be considered as limiting the scope of the disclosure. In the drawings, like numbering represents like elements between the drawings.

### DETAILED DESCRIPTION

In the description herein, reference is made to the accompanying drawings that form a part thereof, and in which is shown by way of illustration specific exemplary embodiments in which the present teachings may be practiced. These embodiments are described in sufficient detail to enable those skilled in the art to practice the present teachings, and it is to be understood that other embodiments may be used and that changes may be made within the scope of the present teachings. The description herein is, therefore, merely illustrative.

As device sizes continue to shrink, the operating parameters for discharge elements such as ESD protection circuits have become increasingly sensitive. For example, the discharge elements need to remain in an "off state" for all operations below a predetermined maximum operating voltage. However, the discharge element(s) need to become active above the predetermined maximum operating voltage but below the breakdown voltage level for the device. Conventional configurations for discharge elements have been unable to provide stable maximum operating voltages that are sufficiently below the breakdown voltage, potentially risking negative side effects to certain devices even where the discharge element(s) operate as intended.

Embodiments of the disclosure provide a circuit structure and method with multiple discharge circuits and a resistor for reducing a discharged pad voltage. A structure of the disclosure includes a first trigger circuit connected between a pad and a ground node. A first discharge circuit is connected between the pad and the ground node, wherein the first discharge circuit is connected to an output node of the first trigger circuit. A second trigger circuit may be connected between the pad and the ground node in parallel with the first trigger circuit. A resistor has a first end connected to the pad and a second end opposite the first end. A second discharge circuit is connected between the second end of the resistor and the ground node. The second discharge circuit is connected to an output node of the first trigger circuit or the second trigger circuit. Related methods are also provided.

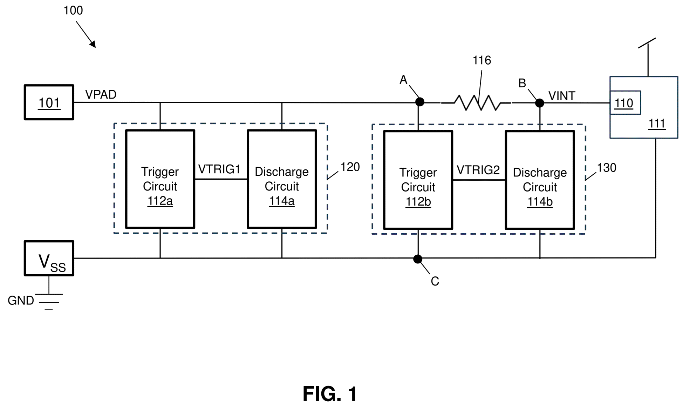

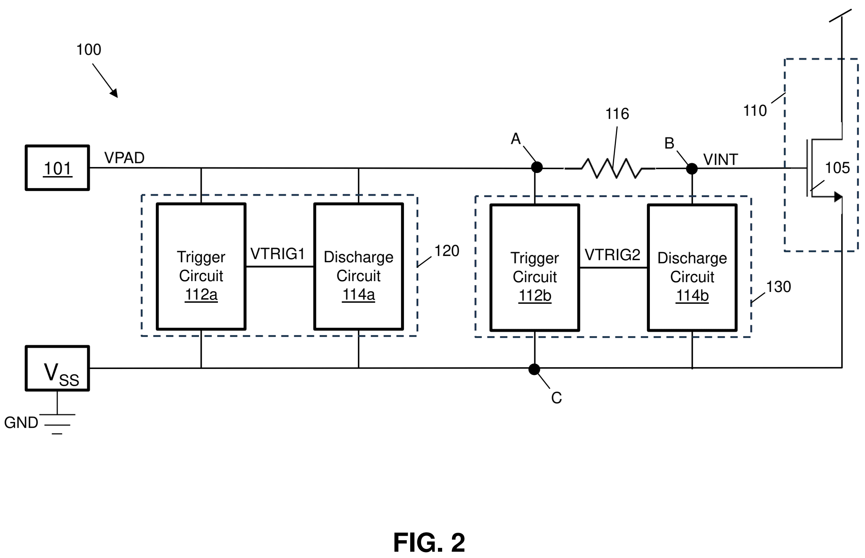

Referring to FIG. 1, a schematic view of a circuit structure (simply "structure" hereafter) 100 according to embodiments of the disclosure is shown. Structure 100 may be embodied as any type of electronic circuit and in various implementations may be provided in the form of, or included as part of, an integrated circuit (IC) structure. Structure 100 may include a pad 101. Pad 101 can be, for example, an input/output ("I/O") pad, a power pad, etc. at risk of suffering from a high voltage operating condition such as an electrostatic discharge (ESD) event. Pad 101 can further be electrically connected to a device 110 of an operational circuit 111 (e.g., a transceiver front-end or other circuit) for performing various functions. According to an example, as illustrated in FIG. 2, device 110 may be a transistor 105 (such as a "grounding transistor") or any other electrically controllable device configured to operate in response to signals from pad 101. Transistor 105 may have a first source/drain (S/D) terminal coupled to at least one other component of device 110, a second S/D terminal coupled to ground pad (GND, e.g., through terminal V_{SS}), and a gate coupled to pad 101 (via resistor 116, as discussed in greater detail below). Structure 100 can be configured, as discussed in greater detail below, to protect device 110 from adverse effects, including possible damage, caused by an ESD event at pad 101.

Structure 100 includes a first node A, tied to pad 101 and several other components (e.g., three components connected in parallel as shown). The gate (or alternatively, switching terminal) of device 110 is coupled to a second node B within structure 100. A resistor 116 has a first end coupled to first node A and a second end opposite the first end coupled to second node B. As discussed herein, one S/D terminal (or other input terminal) of device 110 is coupled other devices (not shown) within operational circuit 101 and the other S/D terminal (or output terminal) is coupled to ground GND at terminal V_{SS} through a third node C. First node A, in particular may be coupled to a first trigger circuit 112a, a first discharge circuit 114a, and a second trigger circuit 112b all connected between nodes A and C in parallel with each other. Device 110 also may include a gate terminal (or other voltage-controlled node for enabling or disabling current flow through device 110) coupled to second node B. Node B is also connected to node C through a second discharge circuit 114b. Device 110, although indicated as a single transistor in FIG. 2 (e.g., a protective transistor or grounding transistor as discussed herein), may be coupled to and/or may include more complex circuitry having several electrically active elements including several resistors, capacitors, diodes, and/or other devices. Additional components and/or circuitry may be coupled to structure 100 through input line Vᵢₙ, but the nature and operation of such components is immaterial to the configuration and operation of structure 100 and thus not discussed in further detail.

In the configuration shown, first node A may be set to the level of the input or "high voltage" input terminal of structure 100, and third node C may be set to the voltage level of the "ground" or "output" (V_{SS}) terminal of structure 100. Second node B may designate the junction between the gate terminal (or other control terminal) of device 110 and second discharge circuit 114b of structure 100, discussed herein. Second node B may be used to control the operation of device 110 but is susceptible to spikes in electrical current during an ESD event as discussed herein. Structure 100 is configured to react to excess charges and currents originating from an ESD event by creating an electrical short to bypass device 110, and simultaneously, reduce the voltage magnitude applied to device 110. During operation, resistor 116 of structure 100 reduces the voltage from an ESD event applied to the gate (or other control terminal) of device 110 ground (V_{SS}) simultaneously by creating one or more intentional electrical shorts through structure 100, e.g., using a first trigger circuit 112a and first discharge circuit 114a and/or a second trigger circuit 112b and second discharge circuit 114b.

Structure 100 may take the form of a clamp configured to create an electrical short from input pad 101 to ground at output terminal V_{SS} without decoupling device 110 from input pad 101. Structure 100 also may be configured to operate under non-ESD conditions with variations in voltage, e.g., by including a connection from input pad 101 to device 110 in operational circuit 111. Structure 100, however, includes additional components configured to be inactive during non-ESD scenarios or within predetermined voltage limits. Trigger circuits 112a, 112b are electrically configured to activate discharge circuits 114a, 114b only when pad voltage VPAD reaches a predetermined magnitude. Trigger circuits 112a, 112b will prevent current from flowing through discharge circuit(s) 114a, 114b so long as such voltage fluctuations are insufficient to trigger the transistor gate(s) of trigger circuits 112a, 112b. Structure 100 thus is designed to create an electrical short circuit from input pad 101 to ground V_{SS} only upon detecting an ESD event. Structure 100, moreover, may include multiple trigger circuits 112a, 112b with different predetermined voltages for activating respective discharge circuits 114a, 114b to prevent excessive voltages (e.g., breakdown voltage or higher voltage levels) from being applied to device 110, but without requiring a large resistive element and/or being overly sensitive to non-ESD voltage spikes.

A first set of ESD elements 120 and a second set of ESD elements 130 each may couple first node A to third node C in parallel with any connections to device 110. A resistor 116 also couples first node A to the gate terminal (or other control terminal) of device 110 at second node B. Structure 100 is connected to a ground node (or ground terminal) V_{SS} at third node C. ESD elements 120, 130 may be activated under varying circumstances during an ESD event to create an electrical short from input pad 101 to ground terminal V_{SS} by responding to voltages or currents on pad 101 that are above a predetermined magnitude for device 110 and/or operational circuit 111 connected thereto. A specific set, or both sets, of ESD elements 120, 130 may be configured to respond to a same or different voltage magnitude on pad 101, e.g., the threshold voltage for trigger circuit 112a in first set of ESD elements 120 may be the same as, or greater than, the threshold voltage for trigger circuit 112b in second set of ESD elements 130. ESD elements 120, 130 may be electrically inactive unless at least their predetermined voltage is applied to a trigger circuit 112a, 112b of ESD element(s) 120, 130. In various other examples, additional circuitry and/or current paths may be located between device 110 and ESD element(s) 120, 130 to further control the circumstances in which ESD elements 120, 130 become electrically active.

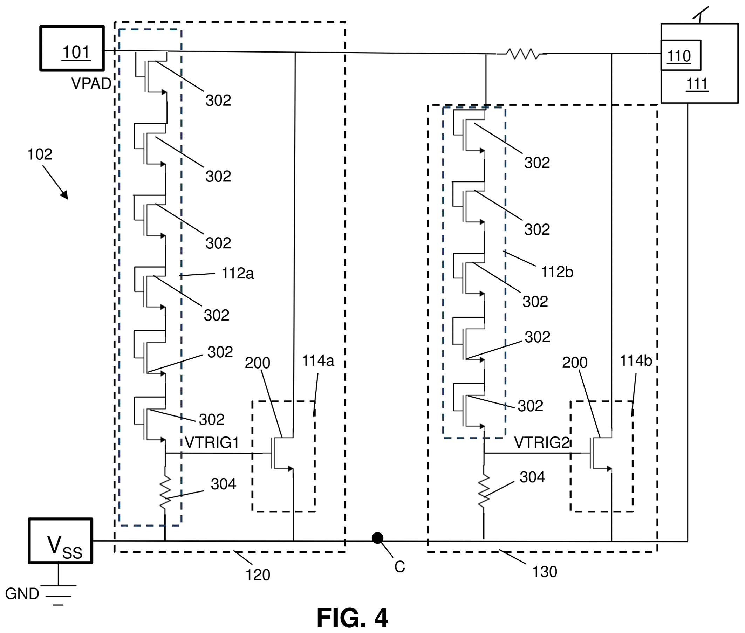

As discussed in further detail herein relative to FIG. 4, each trigger circuit 112a, 112b of structure 100 may include several interconnected transistors, each configured to detect only a predetermined high voltage magnitude at pad 101, e.g., during an ESD event. A transistor refers to an electrical component in which a flow of current between input and output nodes (e.g., source and drain terminals) is controlled by the voltage applied to a third "gate" terminal. Trigger circuits 112a, 112b may include one or more transistors having a gate coupled to terminal A of structure 100, such that a voltage at pad 101 having a predetermined magnitude controls whether each trigger circuit 112a, 112b is turned on or off. Each trigger circuit 112a, 112b may be coupled at its output to a corresponding discharge circuit 114a, 114b. First trigger circuit 112a is coupled to first discharge circuit 114a and second trigger circuit 112b is coupled to second discharge circuit 114b. Trigger circuits 112a, 112b, during operation, remain inactive until a predetermined operating voltage (e.g., an ESD voltage) is applied to trigger circuit 112a, 112b at node A from pad 101. Each trigger circuit 112a, 112b may have a different predetermined operating voltage, e.g., by having a different number and/or arrangement of transistors therein. Upon receiving the predetermined operating voltage, trigger circuit(s) 112a, 112b outputs a trigger voltage (VTRIG1 from first trigger circuit 112a, VTRIG2 from second trigger circuit 112b) to discharge circuit 114a, 114b to enable protective interaction with device 110. Trigger voltages VTRIG1, VTRIG2 may be the same or may be different. Each trigger circuit 112a, 112b enables current flow through discharge circuit 114a, 114b to discharge the gate control terminal of device 110 to ground terminal V_{SS}.

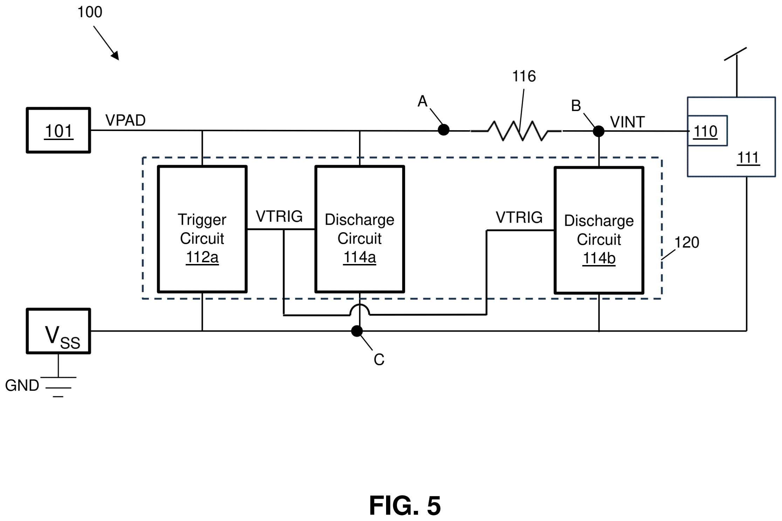

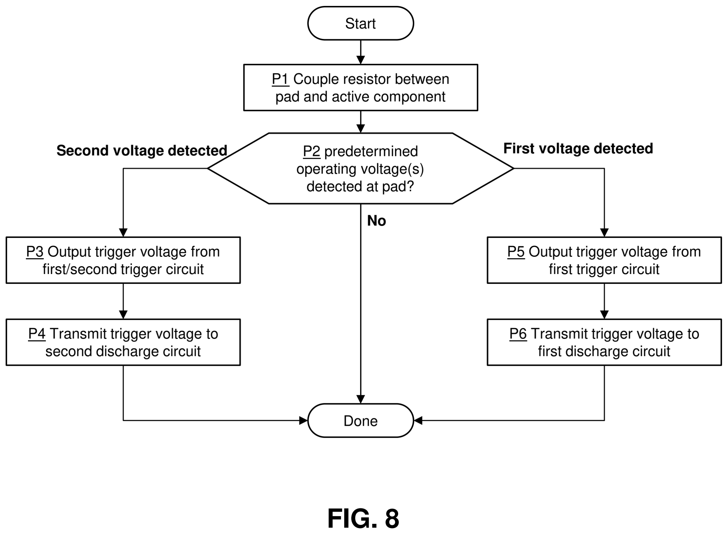

Structure 100 includes resistor 116 with a first end coupled to pad 101 (at first node A) to receive a pad voltage (VPAD) and a second end coupled to second discharge circuit 114b and the gate terminal of device 110 (at second node B). Second node B at the second end of resistor 116 is not coupled to first set of ESD elements 120. Resistor 116 is present in structure 100 to reduce VPAD received at the first end to an intermediate voltage (VINT) of lower magnitude output at the second end (e.g., to device 110, for example, as the gate voltage if device 110 is a transistor with a gate connected to pad 101). The reduction in voltage from first node A to second node B across resistor 116 occurs through application of Ohm's Law, as generally understood in relevant technical art. Second discharge circuit 114b, when activated by second trigger circuit 112b, selectively couples second node B (i.e., the second end of resistor 116) to ground (V_{SS}) at third node C. First discharge circuit 114a is similarly activated by first trigger circuit 112a to selectively couple node A to ground (Vss), but the predetermined voltage magnitude to activate first trigger circuit 112a may be greater than the predetermined voltage magnitude to activate second trigger circuit 112b. In alternative implementations, the predetermined voltage magnitude to activate first trigger circuit 112a may be the same as, or less than, the predetermined voltage magnitude to activate second trigger circuit 112b or only first trigger circuit 112a may be present (see FIGS. 5, 6, 8 herein). During operation, first trigger circuit 112a and first discharge circuit 114a may enable resistor 116 to be electrically bypassed to accommodate higher voltage ESD events.

When first discharge circuit 114a and second discharge circuit 114b are inactive (i.e., no trigger voltages are applied thereto from trigger circuits 112a, 112b), no current will travel from first node A or second node B to third node C via discharge circuits 114a, 114b. In the case where structure 100 includes multiple trigger circuits 112a, 112b each applying a trigger voltage VTRIG1, VTRIG2 to one discharge circuit 114a, 114b (e.g., during an ESD event or other high voltage operating scenario at the predetermined operating voltage), discharge circuit(s) 114a, 114b become active and create an electrical short from first node A or second node B to third node C to ground (V_{SS}). Thus, during an ESD event or other high voltage operating scenario, one current pat his from pad 101 are from first node A to second node B through resistor 116 to the gate terminal of device 110, and subsequently through discharge circuit 114b (due to the trigger voltage applied thereto from trigger circuit 112) to third node C, and to ground GND at terminal V_{SS}. An additional or alternative path is from first node A to third node C through discharge circuit 114b and to ground GND at terminal V_{SS}. A specific one, or both, of these current paths may be enabled under varying voltage conditions at pad 101. During ESD events where the voltage at pad 101 is sufficiently high to activate second trigger circuit 112b but not first trigger circuit 112a, resistor 116 functions to reduce the voltage applied to the gate terminal of device 110 to an intermediate voltage level (VINT) that is less than the high voltage (VPAD) at pad 101.

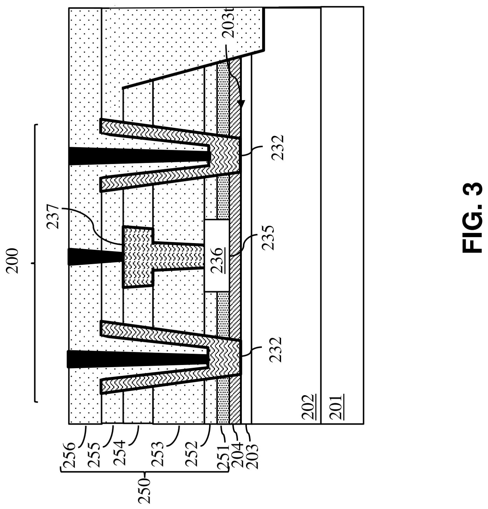

FIG. 3 provides an example of an high electron mobility transistor (HEMT) 200 that may be implemented within discharge circuit(s) 114a, 114b of structure 100. Conventionally, resistive elements in an ESD protective circuit create a risk of the ESD-detecting components not being triggered when a sufficiently high voltage occurs. The incorporation of resistor 116 into structure 100 may be achievable without such risks, in part, by HEMT device architectures within discharge element(s) 114a, 114b. It is emphasized that HEMT 200 as shown in FIG. 3 is an example of a particular device configuration; different devices having different polarities, doping profiles, electrical couplings, etc., may be substituted in discharge element 114a, 114b for embodiments of HEMT 200 as shown herein.

HEMT 200 may be provided using a stack of III-V semiconductor layers at essentially the same level above a substrate. More particularly, in the disclosed embodiments, the semiconductor structure can include a stack of III-V semiconductor layers. HEMT 200 thus may include any conceivable HEMT III-V semiconductor device built on such a structure, e.g., another HEMT enhancement-mode HEMT with or without raised III-V semiconductor source/drain regions, an enhancement-mode MISHEMT with or without raised III-V semiconductor source/drain regions, etc. As discussed herein, HEMT 200 may differ from other transistor architectures by including (among other components) a barrier layer above and immediately adjacent to a III-V semiconductor surface at the top of the stack in a first area. Various isolating materials (e.g., one or more isolation wells) may be within the stack adjacent to the III-V semiconductor surface, e.g., to electrically isolate HEMT 200 from other transistors having different architectures.

FIG. 3 provides a cross-section diagram illustrating an example implementation of HEMT 200. HEMT 200 can include a substrate 201. Substrate 201 can be, for example, a silicon substrate or a silicon-based substrate (e.g., a silicon carbide or silicon germanium substrate), a sapphire substrate, a III-V semiconductor substrate (e.g., a gallium nitride substrate or other suitable III-V semiconductor substrate) or any other substrate suitable for III-V semiconductor processing. HEMT 200 can include a stack of III-V semiconductor layers on substrate 201. Those skilled in the art will recognize that a III-V semiconductor refers to a compound obtained by combining one or more group III elements, such as boron (B), aluminum (Al), gallium (Ga), or indium (In), with one or more group V elements, such as nitrogen (N), phosphorous (P), arsenic (As) or antimony (Sb)). Thus, examples of III-V semiconductors include, but are not limited to, gallium nitride, indium phosphide, gallium arsenide, aluminum gallium nitride, indium gallium nitride, etc. The III-V semiconductor layers of the stack can be epitaxially grown on substrate 201 and can include at least a buffer layer 202 and a channel layer 203 on the buffer layer 202. For example, a buffer layer 202 can be above and immediately adjacent to the top surface of substrate 201.

Buffer layer 202 can be employed as an anchor to achieve nucleation and to duplicate orientation in subsequently grown epitaxial layers. Buffer layer 202 could be, for example, a gallium nitride layer and/or one or more layers of any other III-V semiconductor(s) suitable for use as a buffer layer for a HEMT or metal-insulator-semiconductor HEMT (MISHEMT). Optionally, buffer layer 202 can be carbon-doped or iron-doped. Channel layer 203 can be above and immediately adjacent to the top surface of buffer layer 202. Channel layer 203 could be, for example, a gallium nitride layer and/or one or more layers of any other III-V semiconductor(s) suitable for use as a channel layer of a HEMT or MISHEMT. In any case, the top surface of the stack and, particularly, the top surface of channel layer 203 can be a III-V semiconductor surface 203t.

HEMT 200 can include, among other components discussed in greater detail below, a barrier layer 204 (and, particularly, another III-V semiconductor layer) that is above and immediately adjacent to III-V semiconductor surface 203t. HEMT 200 can further around and/or above various components of HEMT 200. The DM layers 250 can include a first DM layer 251 and, particularly, a silicon nitride layer. The DM layers can optionally include, but are not limited to, one or more of a second DM layer 252, a third DM layer 253, a fourth DM layer 254, a fifth DM layer 255, and a sixth DM layer 256. Any of the DM layers 252-156 can include a single layer of DM (e.g., a silicon dioxide layer or some other suitable DM) or two or more sub-layers of DM (e.g., a conformal silicon nitride layer and a silicon dioxide layer on the conformal silicon nitride layer or some other suitable combination of dielectric material layers).

HEMT 200 additionally includes source/drain terminals 232 on channel layer 203, and a gate terminal 235 on barrier layer 204 positioned laterally between source/drain terminals 232. HEMT 200 can include barrier layer 204 above and immediately adjacent to the III-V semiconductor surface 203t at the top of the stack. Barrier layer 204 can be yet another III-V semiconductor, which is different from channel layer 203 and which has a band gap that is wider than the bandgap of channel layer 203. Those skilled in the art will recognize that the channel and barrier III-V semiconductor materials can be selected so that a heterojunction is formed at the interface between the two layers, thereby resulting in the formation of a two-dimensional electron gas (2DEG) in channel layer 203. This 2DEG in channel layer 203 can provide the conductive pathway for the drifting of charges between source/drain terminals. The minimum voltage magnitude at gate terminal 235 to produce a 2DEG in channel layer 203 is also known as a "threshold voltage" in the case of an E-mode HEMT. Barrier layer 204 could be a layer of aluminum gallium nitride, aluminum nitride or any other III-V semiconductor material suitable for use as a barrier layer (e.g., depending upon the III-V semiconductor material of channel layer 203). In any case, the above-mentioned layers can be epitaxially grown by metal-organic chemical vapor deposition (MOCVD) or any other suitable technique (e.g., molecular beam epitaxy (MBE), hydride vapor phase epitaxy (HVPE), etc.). For purposes of illustration, the figures and the description above depict barrier layer 204 as including a single layer of III-V semiconductor material. However, it should be understood that the figures and description are not intended to be limiting and that, alternatively, barrier layer 204 could include two or more sub-layers of III-V semiconductor materials. First DM layer 251 (which as mentioned above can be a silicon nitride layer) can be above and immediately adjacent to the top surface of barrier layer 204.

HEMT 200 may be configured as an enhancement-mode (E-mode) HEMT. Those skilled in the art will recognize that an E-mode HEMT refers to a HEMT that remains in an "off" (i.e., non-conductive) state when no voltage is applied to its gate. In this case, HEMT 200 may require a threshold voltage to be applied to gate terminal 235 (e.g., a trigger voltage (VTRIG) from trigger circuit 112 (FIG. 1) as discussed herein) to operate to an on-state (i.e., to become conductive). In the case of an E-mode HEMT, HEMT 200 includes a P-type III-V semiconductor layer 236 in gate terminal 235 stacked between barrier layer 204 and gate conductor material 237. P-type III-V semiconductor layer 236 can be, for example, a III-V semiconductor (such as gallium nitride), which is epitaxially grown on barrier layer 204 and which is doped (e.g., with magnesium) so as to have P-type conductivity. In these implementations of HEMT 200, gate conductor material 237 can include metallic gate conductor material(s) so that gate terminal 235 is a Schottky contact gate terminal.

Referring now to FIG. 4, another schematic diagram of structure 100 is shown with example subcomponents for implementing trigger circuits 112a, 112b and discharge circuits 114a, 114b. Discharge circuits 114a, 114b in some implementations, simply may include HEMT 200 coupled from drain to source from first node A (in the case of first discharge circuit 114a) or second node B (in the case of second discharge circuit 114b) to third node C, and at its gate to the source terminal at one end of serially coupled connected transistors 302 within trigger circuits 112a, 112b. As discussed herein, HEMT 200 may be an E-mode HEMT such that current only flows there through from first node A or second node B to third node C concurrently with a trigger voltage applied to the gate of HEMT 200, via first trigger circuit 112a or second trigger circuit 112b where applicable. In various alternative configurations, multiple interconnected HEMTs 200 may be included in discharge circuit(s) 114a, 114b, e.g., an array of interconnected HEMTs configured to function as a larger transistor according to any currently known or later developed "macro transistor" configuration, and/or other sets of interconnected transistors configured to approximate the function(s) of HEMT 200.

Trigger circuits 112a, 112b in contrast to discharge circuits 114a, 114b may include several conventional (e.g., non-HEMT) transistors interconnected together as a plurality of diode-connected transistors 302. A diode-connected transistor refers to a transistor configuration in which the control terminal of a transistor is coupled directly to one of its input-output terminals, thus converting the transistor into a two terminal diode structure. In the case of a metal oxide semiconductor field effect transistor (MOSFET), a diode-connected transistor may feature a drain (or alternatively, source) terminal tied to its gate. According to an example, trigger circuits 112a, 112b each may include a first diode-connected transistor 302 with connected gate and drain terminals coupled to first node A (i.e., neither trigger circuit 112a, 112b is coupled to second node B) and pad 101, a last diode-connected transistor coupled to one terminal of an additional resistor 304, and several intermediate diode-connected transistors 302 (e.g., two shown) connected to each other in series from drain to source between the first and last diode-connected transistors 302. Multiple diode-connected transistors 302 may be implemented in trigger circuits 112a, 112b instead of a single transistor, e.g., to reduce current leakage through trigger circuits 112a, 112b when discharge circuit(s) 114a, 114b is/are not operating (i.e., when high voltage scenarios at the predetermined operating voltage, such as ESD events, are not occurring).

Within each trigger circuit, 112a, 112b, a junction between the source of one diode-connected transistor 302 and one terminal of additional resistor 304 may be tied to the control terminal of discharge circuit 114 (e.g., the gate terminal of HEMT 200) such that the operative state of diode-connected transistors 302 determines whether a trigger voltage is applied to discharge circuit 114a, 114b coupled thereto. Additional resistor 304 in trigger circuit 112a, 112b thus prevents the control terminal of a corresponding discharge circuit 114a, 114b from being connected to ground at terminal V_{SS}. In alternative configurations, the control terminal of discharge circuit(s) 114a, 114b (i.e., the gate of HEMT 200) may be coupled to another node within the corresponding trigger circuit 112a, 112b, e.g., where different circuit configurations are used to perform similar functions. In still further examples discussed herein (e.g., structure100 shown in FIG. 5), one trigger circuit 112 may be coupled to multiple discharge circuits 114a, 114b.

Where multiple trigger circuits 112a, 112b are present, diode-connected transistors 302 may have threshold voltages at a sufficiently high magnitude such that trigger circuits 112a, 112b will not operate until a predetermined high voltage magnitude (different for each trigger circuit 112a, 112b) is applied to structure 100 at pad 101. The threshold voltage for diode-connected transistors 302 in trigger circuit 112a, 112b may be at least equal to the anticipated voltage during an ESD event or similar event(s) with undesirably high voltage magnitudes. Differences in the number of transistors, and/or interconnections therebetween, within each trigger circuit 112a, 112b may cause the voltage for activating first trigger circuit 112a to be different (e.g., larger) than the voltage for activating second trigger circuit 112b. Both trigger voltages are larger than the actual voltage applied to the gate of device 110 and discharged therefrom through HEMT(s) 200 in discharge circuit(s) 114a, 114b. The combination of trigger circuits 112a, 112b (each configured to trigger under higher pad voltage magnitudes than the breakdown voltage of device 110) with resistor 116 (configured to reduce the pad voltage to a lower magnitude than the breakdown voltage of device 110 in the case where only second discharge circuit 114b is active) allows structure 100 to discharge high voltage magnitudes via discharge circuit 114 without overwhelming the control terminal of device 110.

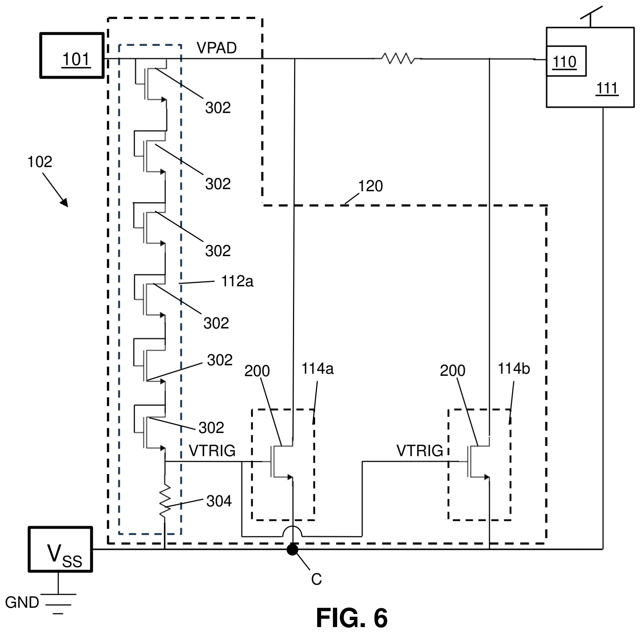

FIGS. 5 and 6 depict further embodiments of structure 100 in which, optionally, only first trigger circuit 112a is configured to control first discharge circuit 114a and second discharge circuit 114b using one voltage (VTRIG). In this configuration, device 110 and operational circuit 111 may be in any of the various forms and/or implementations discussed elsewhere herein (e.g., transistor 105 (FIG. 2)). First set of ESD elements 120 may include first trigger circuit 112a and multiple discharge circuits 114a, 114b. Each discharge circuit 114a, 114b may be coupled to a different terminal of resistor 116. Similar to other embodiments herein, first discharge circuit 114a may be electrically coupled between nodes A (set to pad voltage VPAD) and C (set to V_{SS} or ground). Second discharge circuit 114b also may be electrically coupled between nodes B (set to intermediate voltage VINT) and C (set to V_{SS} or ground). First discharge circuit 114a is thus configured to discharge pad voltage VPAD and second discharge circuit 114b is configured to discharge intermediate voltage VINT. In this arrangement, however, first trigger circuit 112a includes one output node coupled in parallel to the control nodes of first discharge circuit 114a and second discharge circuit 114b.

Although first trigger circuit 112a outputs only one voltage VTRIG to electrically control multiple discharge circuits 114a, 114b, each discharge circuit 114a, 114b may be activated in response to different voltage magnitudes. For instance, second discharge circuit 114b may be enabled when VTRIG reaches a magnitude that is less than the trigger voltage needed to enable first discharge circuit 114a. Discharge circuits 114a, 114b may activate in response to different voltage magnitudes, e.g., by being implemented with HEMTs or other transistors having different threshold voltages attributed to physical and/or electrical differences. For instance, HEMT(s) 200 in second discharge circuit 114b may be approximately six times smaller than HEMT(s) 200 in first discharge circuit 114a, or HEMT(s) 200 may otherwise be different enough in size to have substantial differences in their activation voltages. In further configurations, the voltage magnitude to activate each discharge circuits 114a, 114b may be controlled by other elements (e.g., resistors, capacitors, etc.) coupled between first trigger circuit 112a and discharge circuit(s) 114a, 114b. For ESD events having a lower voltage magnitude, second discharge circuit 114b may discharge intermediate voltage VINT. For ESD events having a higher voltage magnitude, first discharge circuit 114a may discharge pad voltage VPAD. In this configuration, first trigger circuit 112a is operable to discharge different voltages from first node A or second node B, due to the presence of resistor 116 and multiple discharge circuits 114a, 114b.

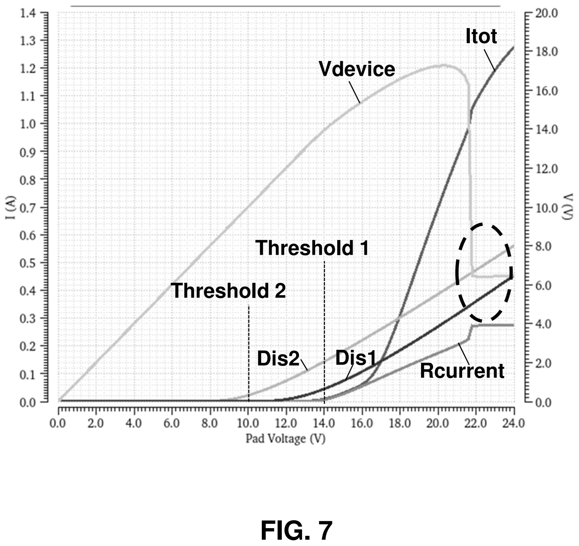

Referring to FIGS. 1, 5, and 7 together, technical benefits of structure 100 are discussed in further detail relative to conventional protective circuit structures. The technical benefits discussed herein may be realized regardless of which configuration(s) of structure 100, shown in FIGS. 1, 2, and 4-6 and discussed herein, or another implementation of structure 100, is implemented. FIG. 7 provides comparative voltage plots and corresponding current plots for different amounts of pad voltage (VPAD) applied to structure 100. The left Y axis indicates the total current (Itot) through structure 100 and the right Y axis indicates the voltage applied to device 110 (Vdevice), i.e., the voltage at second node B. The X axis represents the input voltage applied at pad 101. The example plot of FIG. 7 also indicates the voltage at the control node of each discharge circuit ("Dis1" for first discharge circuit 114a, "Dis2" for second discharge circuit 112b) and the current through resistor 116 ("Rcurrent"). Dashed lines also indicate example values for the voltage magnitude(s) to activate first discharge circuit 114a ("threshold 1") and second discharge circuit 114b ("threshold 2"). Each voltage may be applied by one trigger circuit (112a, 112b, respectively) or just first trigger circuit 112a as discussed herein. The example plot in FIG. 7 thus indicates how changes in the pad voltage applied at first node A will affect control terminal voltages to device 110 at node B (via Vdevice), as well as the ensuing currents through discharge circuits 114a, 114b (via Dis1 and Dis2) when trigger circuit 112 activates. In a conventional ESD protective device without resistor 116 or similar resistive elements, there is essentially no resistance between nodes A and B and thus the conventional circuit has a resistance "R" value of zero ohms (Ω).

In an example implementation of structure 100, second discharge circuit 114b is activated by voltages of at least approximately ten V and first discharge circuit 114a is activated by voltages of at least approximately fourteen V. A voltage of at least approximately ten V may indicate an ESD event, whereas a voltage of at least approximately fourteen V may indicate a higher voltage ESD event where structure 100 must discharge more electric potential to ground. For lower ESD voltages at pad 101, e.g., those between approximately ten and fourteen V, only second discharge circuit 114b is enabled and carries ESD currents to ground at intermediate voltage VINT.

For higher ESD voltages at pad 101, e.g., those above approximately fourteen V, first discharge circuit 114a and second discharge circuit 114b are each enabled and thus multiple circuits 114a, 114b discharge ESD currents to ground. Resistor 116 (Having a value of, e.g., approximately four Ω) will saturate for still greater voltages (e.g., pad 101 has a voltage of at least approximately twenty-two V) and thus will not carry additional current even as the voltage at pad 101 increases. FIG. 7 indicates current saturation by Rcurrent remaining at approximately 0.25A even as pad voltage increases beyond twenty-two V. Thus, structure 100 can accommodate even higher voltages during ESD events by reducing the voltage at device 110 (i.e., at node B) to VINT. These aspects of structure 100 according to any embodiment herein thus cause the voltage at device 110 (Vdevice) to reach its maximum value at approximately seventeen volts, significantly below its breakdown voltage, before decreasing to approximately six V even as total current (Itot) continues to increase along a linear profile.

Referring now to FIGS. 1, 5, and 7 together, embodiments of the disclosure provide methods to operate structure(s) 100 such that, during an ESD event or other high voltage operation, device 110 may have an intermediate voltage at second node B that is less than the voltage at first node A for activating trigger circuit 112, but in which the entire ESD voltage at pad 101 discharges to ground when undergoing higher magnitude ESD events. Process P1 in methods of the disclosure may include coupling resistor 116 between pad 101 (at first node A) and device 110 (at second node B) in structure 100. Resistor 116 in this position is operable to create a voltage drop from first node A to second node B, and without disconnecting device 110 from pad 101, when first trigger circuit 112a (e.g., in FIG. 5 implementation) or second trigger circuit 112b (e.g., in FIG. 1 implementation) activates second discharge circuit 114b to create a current pathway between pad 101 and ground (at terminal V_{SS}) through resistor 116. The coupling of resistor 116 between nodes A, B in process P1 thus may produce structure 100 as discussed herein.

An ESD event or other high voltage operation may create a sufficiently high voltage at first node A to activate trigger circuit(s) 112a, 112b of structure 100. Due to the configuration of trigger circuit(s) 112a, 112b and discharge circuits 114a, 114b in structure 100, Process P2 includes detecting whether either of the predetermined operating voltages are received at pad 101. Where the voltage at pad 101 is insufficient to activate trigger circuit(s) 112a, 112b, the method may conclude ("Done") and structure 100 may remain inactive until one of the predetermined operating voltages is detected at pad 101. Otherwise, process P2 simply may include any process that applies a sufficient voltage to activate one or more of trigger circuits 112a, 112b, e.g., applying at least a predetermined operating voltage to diode connected transistor 302s (FIG. 4, 6) within trigger circuit(s) 112a, 112b.

Where the lower of the two predetermined operating voltages (i.e., the "second operating voltage" in this example) is detected at pad 101, structure 100 implements processes P3 and P4 using trigger circuit(s) 112a, 112b and second discharge circuit 114b. In process P3, trigger circuit(s) 112a, 112b output a trigger voltage (VTRIG or VTRIG2, respectively) in response to pad 101 being set to the second predetermined operating voltage. Thereafter, the trigger voltage (VTRIG from first trigger circuit 112a or VTRIG2 from second trigger circuit 112b, depending on configuration) activates second discharge circuit 114b.

The activating of trigger circuit(s) 112a, 112b, alone, may not create an electrical pathway from pad 101 to output pad V_{SS} through structure 100. Second discharge circuit 114b is coupled between nodes B and C in structure 100 to transmit intermediate voltage VINT to V_{SS} (ground). When trigger circuit(s) 112a, 112b activate second discharge circuit 114b, second discharge circuit 114b in process P3 creates a current pathway from second node B to third node C. Where second discharge circuit 114b includes one or more HEMTs 200 (FIGS. 4, 6), process P3 simply may include outputting a trigger voltage from trigger circuit(s) 112a, 112b with a magnitude equal to, or greater than, a threshold voltage to the gate terminal of the E-mode HEMT(s) 200. Process P4 thus can include transmitting trigger voltage VTRIG or VTRIG2 (depending on the trigger circuit(s) 112a, 112b connected thereto) to second discharge circuit 114b in structure 100. As discussed herein, applying trigger voltage VTRIG to second discharge circuit 114b (e.g., at HEMT(s) 200 thereof) will enable current to travel from drain to source from second node B (tied to the gate or control terminal of device 110) to third node C. Due to the presence of resistor 116 between first node A and second node B, the voltage drop across resistor 116 will cause device 110 at second node B to have an intermediate voltage that is less than the voltage at pad 101 (e.g., less than the high voltage created during an ESD event) to avoid negatively affecting device 110.

Where the higher of the two predetermined operating voltages (i.e., the "first operating voltage" in this example) is detected at pad 101, structure 100 may provide additional pathways for connecting pad 101 to ground, in parallel with resistor 116. Detecting the first operating voltage may initiate processes P5, P6 of using first trigger circuit 112a to activate first discharge circuit 114a. Regardless of how structure 100 is implemented, only first trigger circuit 112a and first discharge circuit 114a may be manipulated in processes P5, P6. In process P5, the detected voltage at pad 101 is transmitted to first trigger circuit 112a. First trigger circuit 112a may have a gate or other control node with a higher predetermined voltage than second trigger circuit 112b, e.g., a sufficiently high voltage may trigger first trigger circuit 112a in addition to second trigger circuit 112b. In implementations where second trigger circuit 112b is not present, the voltage at first trigger circuit 112a may increase the magnitude of VTRIG from first trigger circuit 112a to a sufficient extent to activate first discharge circuit 114a and second discharge circuit 114b simultaneously. In process P6, first trigger circuit 112a transmits trigger voltage VTRIG or VTRIG1 to first discharge circuit 114a, thereby creating an additional current electrical pathway from first node A to third node C in parallel with the path through nodes A, B, and C along resistor 116. In this configuration, and under higher magnitude ESD voltages, the current through resistor 116 will saturate at a predetermined voltage (e.g., twenty-two V as shown by example in FIG. 7) to protect device 110. These processes, when implemented, may protect device 110 and other circuitry of a device from being harmed by high voltage events, while simultaneously preventing device 110 from operating above its breakdown voltage due to the presence of resistor 116. These technical benefits and related advantages may be further pronounced in implementations where discharge circuits 114a, 114b include HEMT(s) 200 but trigger circuits 112a, 112b do not include any HEMT devices therein.

Embodiments of the disclosure may provide several technical and commercial advantages, some of which are discussed by example herein. Embodiments of structure 100 provide, e.g., a structure capable of responding to ESD events with conventional trigger voltage magnitudes, without applying voltages applied to device 110 that are near its breakdown voltage. During operation, structure 100 with multiple discharge circuits 114a, 114b and, optionally, multiple trigger circuits 112a, 112b reduces current leakage through structure 100 during non-ESD operations and the clamping voltage of structure 100 in various applications. In addition, compared to conventional ESD protective circuitry, structure 100 may implement lower magnitude resistors and thus may occupy a lower amount of surface area. Device 110 may remain coupled to pad 101 during such events, and have an intermediate voltage applied thereto, due to the inclusion of resistor 116. Embodiments of the disclosure avoid the conventional penalties to size and performance associated with forming a resistor in an ESD protective circuit by using HEMTs or similar architectures to provide discharge pathways. These advantages, in turn may provide lower leakage currents regardless of the operating state of structure 100 and may provide greater protection against high voltage events by accommodating a wider range of voltages before the intermediate voltage approaches the breakdown voltage of device 110.

The descriptions of the various embodiments of the present disclosure have been presented for purposes of illustration, but are not intended to be exhaustive and/or limited to the embodiments disclosed. Many modifications and variations will be apparent to those of ordinary skill in the art within the scope and spirit of the described embodiments The terminology used herein was chosen to best explain the principles of the embodiments, the practical application and/or technical improvement over technologies found in the marketplace, and/or to enable others of ordinary skill in the art to understand the embodiments disclosed herein.

In summary, embodiments of the disclosure provide a circuit structure and method with multiple discharge circuits and a resistor for reducing a discharged pad voltage. A structure of the disclosure includes a first trigger circuit connected between a pad and a ground node. A first discharge circuit is connected between the pad and the ground node, wherein the first discharge circuit is connected to an output node of the first trigger circuit. A second trigger circuit may be connected between the pad and the ground node in parallel with the first trigger circuit. A resistor has a first end connected to the pad and a second end opposite the first end. A second discharge circuit is connected between the second end of the resistor and the ground node. The second discharge circuit is connected to an output node of the first trigger circuit or the second trigger circuit. Related methods are provided.

The following embodiments are explicitly disclosed.

### Embodiment 1:

A structure comprising:
a first trigger circuit connected between a pad and a ground node;
a first discharge circuit connected between the pad and the ground node, wherein the first discharge circuit is connected to an output node of the first trigger circuit;
a second trigger circuit connected between the pad and the ground node in parallel with the first trigger circuit;
a resistor having a first end connected to the pad and a second end opposite the first end; and
a second discharge circuit connected between the second end of the resistor and the ground node, wherein the second discharge circuit is connected to an output node of the second trigger circuit.

### Embodiment 2:

The structure of embodiment 1, wherein the first trigger circuit, the second trigger circuit, and the first discharge circuit are connected to a shared node between the pad and the first end of the resistor, wherein the first trigger circuit and the second trigger circuit are each configured to output a trigger voltage in response to detecting a pad voltage above a predetermined operating voltage, wherein the predetermined operating voltage for the first trigger circuit is different from the predetermined operating voltage for the second trigger circuit.

### Embodiment 3:

The structure of embodiment 2, wherein the predetermined operating voltage for the first trigger circuit is less than the predetermined operating voltage for the second trigger circuit.

### Embodiment 4:

The structure of embodiment 2 or 3, wherein each trigger circuit includes:
a plurality of diode-connected field effect transistors connected in series between the pad and the output node; and
an additional resistor connected between the output node and the ground node, wherein the trigger voltage is generated and output at the output node.

### Embodiment 5:

The structure of one of embodiments 1 to 4, wherein each discharge circuit includes an enhancement mode high electron mobility transistor (HEMT), and wherein the HEMT of the first discharge circuit is larger than the HEMT of the second discharge circuit.

### Embodiment 6:

The structure of embodiment 5, wherein the first trigger circuit has a larger number of diode-connected field effect transistors than the first trigger circuit.

### Embodiment 7:

The structure of one of embodiments 1 to 6, wherein the resistor reduces a voltage received from the pad at the first end to an intermediate voltage at the second end, and wherein the second discharge circuit is configured to receive a second trigger voltage from the second trigger circuit and, in response to the second trigger voltage, discharge the intermediate voltage.

### Embodiment 8:

A structure comprising:
a trigger circuit connected between a pad and a ground node;
a first discharge circuit connected between the pad and the ground node, wherein the first discharge circuit is connected to an output node of the trigger circuit;
a resistor having a first end connected to the pad and a second end opposite the first end; and
a second discharge circuit connected between the second end of the resistor and the ground node, wherein the second discharge circuit is connected to the output node of the trigger circuit.

### Embodiment 9:

The structure of embodiment 8 wherein the first trigger circuit and the first discharge circuit are connected to a shared node between the pad and the first end of the resistor, and wherein the trigger circuit is configured to output a trigger voltage in response to detecting a pad voltage above a predetermined operating voltage.

### Embodiment 10:

The structure of embodiment 8 or 9, wherein each discharge circuit includes an enhancement mode high electron mobility transistor (HEMT), and wherein the HEMT of the first discharge circuit is larger than the HEMT of the second discharge circuit.

### Embodiment 11:

The structure of one of embodiments 8 to 10, wherein the trigger circuit is configured to output a trigger voltage as a first trigger voltage to the first discharge circuit, and as a second trigger voltage to the second discharge circuit, in response to detecting a pad voltage above a predetermined operating voltage.

### Embodiment 12:

The structure of embodiment 11, wherein the trigger circuit includes:
a plurality of diode-connected field effect transistors connected in series between the pad and the output node; and
an additional resistor connected between the output node and the ground node, wherein the trigger voltage is generated and output at the output node.

### Embodiment 13:

The structure of one of embodiments 8 to 12, wherein the second discharge circuit is free of direct electrical couplings to the pad.

### Embodiment 14:

The structure of one of embodiments 8 to 13, wherein the resistor reduces a voltage received from the pad at the first end to an intermediate voltage at the second end, and wherein the second discharge circuit is configured to receive a second trigger voltage from the trigger circuit and, in response to the second trigger voltage, discharge the intermediate voltage.

### Embodiment 15:

A method comprising:
providing a structure including: a pad; a first discharge circuit connected between the pad and a ground node; a resistor having a first end connected to the pad and a second end opposite the first end; and a second discharge circuit connected between the second end of the resistor and the ground node;
enabling the first discharge circuit when a pad voltage on the pad is above a first predetermined operating voltage; and
concurrently enabling the second discharge circuit when the pad voltage on the pad is above a second predetermined operating voltage.

### Embodiment 16:

The method of embodiment 15, wherein the first predetermined operating voltage is different from the second predetermined operating voltage.

### Embodiment 17:

The method of embodiment 15 or 16, wherein the first predetermined operating voltage is less than the second predetermined operating voltage.

### Embodiment 18:

The method of one of embodiments 15 to 17, wherein each discharge circuit includes an enhancement mode high electron mobility transistor (HEMT) having a gate coupled to the first trigger circuit or the second trigger circuit, a first source/drain (S/D) terminal coupled to the second end of the resistor, and a second S/D terminal coupled to ground.

### Embodiment 19:

The method of one of embodiments 15 to 18, further comprising providing a first trigger circuit coupled between the pad and the first discharge circuit, and a second trigger circuit coupled between the pad and the second discharge circuit, wherein each trigger circuit includes:
a plurality of diode-connected field effect transistors connected in series between the I/O pad and the output node; and
an additional resistor connected between the output node and the ground, wherein the first trigger voltage or the second trigger voltage is generated and output at the output node.

### Embodiment 20:

The method of embodiment 19, wherein the first trigger circuit has a larger number of diode-connected field effect transistors than the first trigger circuit.

### Embodiment 21:

A structure comprising:
a first trigger circuit connected between a pad and a ground node;
a first discharge circuit connected between the pad and the ground node, wherein the first discharge circuit is connected to an output node of the first trigger circuit;
a second trigger circuit connected between the pad and the ground node in parallel with the first trigger circuit;
a resistor having a first end connected to the pad and a second end opposite the first end; and
a second discharge circuit connected between the second end of the resistor and the ground node, wherein the second discharge circuit is connected to an output node of the second trigger circuit.

### Embodiment 22:

The structure of embodiment 21, wherein the first trigger circuit, the second trigger circuit, and the first discharge circuit are connected to a shared node between the pad and the first end of the resistor, wherein the first trigger circuit and the second trigger circuit are each configured to output a trigger voltage in response to detecting a pad voltage above a predetermined operating voltage, wherein the predetermined operating voltage for the first trigger circuit is different from the predetermined operating voltage for the second trigger circuit.

### Embodiment 23:

The structure of embodiment 22, wherein the predetermined operating voltage for the first trigger circuit is less than the predetermined operating voltage for the second trigger circuit; and/or wherein each trigger circuit includes:
a plurality of diode-connected field effect transistors connected in series between the pad and the output node; and
an additional resistor connected between the output node and the ground node, wherein the trigger voltage is generated and output at the output node.

### Embodiment 24:

The structure of one of embodiments 21 to 23, wherein the first trigger circuit has a larger number of diode-connected field effect transistors than the first trigger circuit.

### Embodiment 25:

A structure comprising:
a trigger circuit connected between a pad and a ground node;
a first discharge circuit connected between the pad and the ground node, wherein the first discharge circuit is connected to an output node of the trigger circuit;
a resistor having a first end connected to the pad and a second end opposite the first end; and
a second discharge circuit connected between the second end of the resistor and the ground node, wherein the second discharge circuit is connected to the output node of the trigger circuit.

### Embodiment 26:

The structure of embodiment 25 wherein the first trigger circuit and the first discharge circuit are connected to a shared node between the pad and the first end of the resistor, and wherein the trigger circuit is configured to output a trigger voltage in response to detecting a pad voltage above a predetermined operating voltage.

### Embodiment 27:

The structure of embodiment 25 or 26, wherein the trigger circuit is configured to output a trigger voltage as a first trigger voltage to the first discharge circuit, and as a second trigger voltage to the second discharge circuit, in response to detecting a pad voltage above a predetermined operating voltage.

### Embodiment 28:

The structure of one of embodiments 25 to 27, wherein the trigger circuit includes:
a plurality of diode-connected field effect transistors connected in series between the pad and the output node; and
an additional resistor connected between the output node and the ground node, wherein the trigger voltage is generated and output at the output node.

### Embodiment 29:

The structure of one of embodiments 21 to 28, wherein the second discharge circuit is free of direct electrical couplings to the pad.

### Embodiment 30:

The structure of one of embodiments 21 to 29, wherein each discharge circuit includes an enhancement mode high electron mobility transistor (HEMT), and wherein the HEMT of the first discharge circuit is larger than the HEMT of the second discharge circuit.

### Embodiment 31:

The structure of one of embodiments 21 to 30, wherein the resistor reduces a voltage received from the pad at the first end to an intermediate voltage at the second end, and wherein the second discharge circuit is configured to receive a second trigger voltage from the trigger circuit and, in response to the second trigger voltage, discharge the intermediate voltage.

### Embodiment 32:

A method comprising:
providing a structure including: a pad; a first discharge circuit connected between the pad and a ground node; a resistor having a first end connected to the pad and a second end opposite the first end; and a second discharge circuit connected between the second end of the resistor and the ground node;
enabling the first discharge circuit when a pad voltage on the pad is above a first predetermined operating voltage; and
concurrently enabling the second discharge circuit when the pad voltage on the pad is above a second predetermined operating voltage.

Embodiment 33. The method of embodiment 32, wherein the first predetermined operating voltage is different from the second predetermined operating voltage, the first predetermined operating voltage preferably being less than the second predetermined operating voltage.

### Embodiment 34:

The method of embodiment 32 or 33, wherein each discharge circuit includes an enhancement mode high electron mobility transistor (HEMT) having a gate coupled to the first trigger circuit or the second trigger circuit, a first source/drain (S/D) terminal coupled to the second end of the resistor, and a second S/D terminal coupled to ground.

### Embodiment 35:

The method of one of embodiments 32 to 34, further comprising providing a first trigger circuit coupled between the pad and the first discharge circuit, and a second trigger circuit coupled between the pad and the second discharge circuit, wherein each trigger circuit includes:
a plurality of diode-connected field effect transistors connected in series between the I/O pad and the output node; and
an additional resistor connected between the output node and the ground, wherein the first trigger voltage or the second trigger voltage is generated and output at the output node, wherein the first trigger circuit preferably has a larger number of diode-connected field effect transistors than the first trigger circuit.Embodiment 36:
   The method of one of embodiments of 15 to 20 or 32 to 34, wherein the method operates the structure of one of embodiments 1 to 14 or 21 to 31.

## Claims

1. A structure comprising:
a first trigger circuit connected between a pad and a ground node;
a first discharge circuit connected between the pad and the ground node, wherein the first discharge circuit is connected to an output node of the first trigger circuit;
a second trigger circuit connected between the pad and the ground node in parallel with the first trigger circuit;
a resistor having a first end connected to the pad and a second end opposite the first end; and
a second discharge circuit connected between the second end of the resistor and the ground node, wherein the second discharge circuit is connected to an output node of the second trigger circuit.

2. The structure of claim 1, wherein the first trigger circuit, the second trigger circuit, and the first discharge circuit are connected to a shared node between the pad and the first end of the resistor, wherein the first trigger circuit and the second trigger circuit are each configured to output a trigger voltage in response to detecting a pad voltage above a predetermined operating voltage, wherein the predetermined operating voltage for the first trigger circuit is different from the predetermined operating voltage for the second trigger circuit.

3. The structure of claim 2, wherein the predetermined operating voltage for the first trigger circuit is less than the predetermined operating voltage for the second trigger circuit; and/or wherein each trigger circuit includes:
a plurality of diode-connected field effect transistors connected in series between the pad and the output node; and
an additional resistor connected between the output node and the ground node, wherein the trigger voltage is generated and output at the output node.

4. The structure of one of claims 1 to 3, wherein the first trigger circuit has a larger number of diode-connected field effect transistors than the first trigger circuit.

5. A structure comprising:
a trigger circuit connected between a pad and a ground node;
a first discharge circuit connected between the pad and the ground node, wherein the first discharge circuit is connected to an output node of the trigger circuit;
a resistor having a first end connected to the pad and a second end opposite the first end; and
a second discharge circuit connected between the second end of the resistor and the ground node, wherein the second discharge circuit is connected to the output node of the trigger circuit.

6. The structure of claim 5 wherein the first trigger circuit and the first discharge circuit are connected to a shared node between the pad and the first end of the resistor, and wherein the trigger circuit is configured to output a trigger voltage in response to detecting a pad voltage above a predetermined operating voltage.

7. The structure of claim 5 or 6, wherein the trigger circuit is configured to output a trigger voltage as a first trigger voltage to the first discharge circuit, and as a second trigger voltage to the second discharge circuit, in response to detecting a pad voltage above a predetermined operating voltage.

8. The structure of one of claims 5 to 7, wherein the trigger circuit includes:
a plurality of diode-connected field effect transistors connected in series between the pad and the output node; and
an additional resistor connected between the output node and the ground node, wherein the trigger voltage is generated and output at the output node.

9. The structure of one of claims 1 to 8, wherein the second discharge circuit is free of direct electrical couplings to the pad.

10. The structure of one of claims 1 to 9, wherein each discharge circuit includes an enhancement mode high electron mobility transistor (HEMT), and wherein the HEMT of the first discharge circuit is larger than the HEMT of the second discharge circuit.

11. The structure of one of claims 1 to 10, wherein the resistor reduces a voltage received from the pad at the first end to an intermediate voltage at the second end, and wherein the second discharge circuit is configured to receive a second trigger voltage from the trigger circuit and, in response to the second trigger voltage, discharge the intermediate voltage.

12. A method comprising:
providing a structure including: a pad; a first discharge circuit connected between the pad and a ground node; a resistor having a first end connected to the pad and a second end opposite the first end; and a second discharge circuit connected between the second end of the resistor and the ground node;
enabling the first discharge circuit when a pad voltage on the pad is above a first predetermined operating voltage; and
concurrently enabling the second discharge circuit when the pad voltage on the pad is above a second predetermined operating voltage.

13. The method of claim 12, wherein the first predetermined operating voltage is different from the second predetermined operating voltage, the first predetermined operating voltage preferably being less than the second predetermined operating voltage.

14. The method of claim 12 or 13, wherein each discharge circuit includes an enhancement mode high electron mobility transistor (HEMT) having a gate coupled to the first trigger circuit or the second trigger circuit, a first source/drain (S/D) terminal coupled to the second end of the resistor, and a second S/D terminal coupled to ground.

15. The method of one of claims 12 to 14, further comprising providing a first trigger circuit coupled between the pad and the first discharge circuit, and a second trigger circuit coupled between the pad and the second discharge circuit, wherein each trigger circuit includes:
a plurality of diode-connected field effect transistors connected in series between the I/O pad and the output node; and
an additional resistor connected between the output node and the ground, wherein the first trigger voltage or the second trigger voltage is generated and output at the output node, wherein the first trigger circuit preferably has a larger number of diode-connected field effect transistors than the first trigger circuit.
